# EUROPEAN PATENT APPLICATION

(11) **EP 1 614 467 A2**
(43) Date of publication of application: **11.01.2006**
(21) Application number: 05254085.3
(22) Date of filing: 29.06.2005
(51) Int. Cl.: B01L 3/00, B81B 1/00

(54) **Method of forming buried channels and microfluidic devices having the same**

(30) Priority: 30.06.2004 US 881701
(71) Applicant: STMicroelectronics, Inc., Carrollton, TX 75006-5039 (US)
(72) Inventor: Zamanian, Mehdi, Carrollton, Texas 75010 (US)
(74) Representative: Style, Kelda Camilla Karen

(57) **Abstract**

A method of manufacturing an integrated device that includes filling at least one channel region of a substrate with a sacrificial material to form a filled channel, forming an encapsulating layer over the filled channel, forming an aperture in the encapsulating layer, and selectively removing the sacrificial material in the channel region is described. The sacrificial material and etchant can be selected so that the sacrificial material is etched faster than the substrate and/or encapsulating layer. An integrated device having a substrate, at least one channel formed in the substrate, an encapsulating layer located over the substrate and over at least a portion of the channel, the encapsulating layer having at least one aperture located over the channel is also described.

## Description

### BACKGROUND OF THE INVENTION

The treatment of some fluids involves an increasingly precise temperature regulation. In particular when chemical or biochemical reactions are involved precise temperature regulation is often required to minimize undesirable side reactions. And especially in biochemical application, the ability to use very small amounts of fluid is desirable due to the cost or scarcity of larger amounts of the fluids to be analyzed.

One example of a biochemical reaction where temperature regulation is important is the DNA amplification process, also called the Polymerase Chain Reaction process, or PCR. In PCR thermal cycles, various steps of the process are repeated many times to amplify the sample DNA to a detectable level. But there is a need to avoid as far as possible thermal gradients in the fluid reaction areas to provide a uniform reaction environment for the sample in order to obtain a good reaction efficiency or even to obtain the desired reaction product at all.

Other types of processes would also benefit from devices that are capable of fluid treatment and of handling small sample quantities and precisely heating the reaction zone through which the sample is passed. For example, chemical and/or pharmacological analyses, biological tests, and combinatorial chemical synthesis could each benefit from such devices.

Another feature that may aid the ability to control thermal gradients in a microchip reactor is the ability to provide a reaction environment that is substantially covered. Such structures may allow heat to be distributed over the top of the reaction area and also reduce contamination of the reaction fluid. Some microreactors are manufactured using standard photolithographic procedures on which surface channels are made. The channels are covered by thermally bonding a covering plate over the surface containing the exposed channels. But covering the entire surface of the device to seal the channels reduces the flexibility of the options for device designs and complicates the manufacturing process.

### BRIEF SUMMARY OF THE INVENTION

Embodiments of the inventions described herein provide devices having substantially covered channels by conventional semiconductor fabrication techniques. In one aspect embodiments of the invention provide a process for manufacturing a semiconductor device that includes filling at least one channel region of a substrate with a sacrificial material to form a filled channel; forming an encapsulating layer over the filled channel; forming at least one aperture in the encapsulating layer; selectively removing the sacrificial material in the channel region. In particular embodiments, the rate at which an etchant removes the sacrificial material is faster than the rate at which the etchant removes the metal oxide material.

In some embodiments, the substrate comprises silicon, including polysilicon, silicon dioxide or an organic polymer. Particular embodiments include a substrate that is formed over a primary support such as a silicon wafer. Some embodiments of the process described herein optionally include providing an etch stop layer, such as silicon, silicon nitride, silicon dioxide or titanium nitride located under the substrate and in particular embodiments interposing the substrate and the primary support.

In some embodiments, the sacrificial material that fills the trench formed in the substrate is a spin-on-glass (SOG). Some suitable spin-on-glasses include silica, organosilicate and doped silica compositions. In some embodiments of the invention the sacrificial layer has a faster etching rate than the metal oxide layer. In some embodiments, the sacrificial material is removed by using hydrofluoric acid (HF) or a solution thereof as the etchant. In a particular embodiment, the sacrificial material is a spin-on-glass and the etchant is a solution of HF. Where the sacrificial material is a SOG, it is preferable to perform a heating step to degas and cure the SOG after its deposition in the trench.

In still other embodiments, some processes described herein include forming an encapsulating layer comprising an insulating or conductive material. Some suitable insulating or conductive encapsulating materials include silicon dioxide, silicon, silicon nitride, silicon carbide, silicon oxide nitrides, silicon carbide nitrides, aluminum, aluminum nitride, titanium, titanium nitride, tantalum, tantalum nitride, tungsten, tungsten carbide, and tungsten nitride or combinations thereof.

In another aspect, embodiments of the invention provide an integrated device having a substrate, optionally formed on a primary support, where the substrate has a channel formed therein; an encapsulating layer located over the substrate and over at least a portion of the channel, the encapsulating layer having at least one aperture located over the channel.

In some embodiments, the substrate comprises a monolithic silicon substrate, polysilicon, silicon dioxide, or an organic polymer. In other embodiments, the integrated device comprises a primary support under the substrate. One suitable primary support is a silicon wafer. Optionally, the primary support can be an organic polymer such as polyethylene or polypropylene.

In some embodiments, the encapsulating layer comprises an insulating or conductive layer comprising silicon dioxide, silicon, or silicon nitride, silicon carbide, silicon oxide nitrides, silicon carbide nitrides, aluminum, aluminum nitride, titanium, titanium nitride, tantalum, tantalum nitride, tungsten, tungsten carbide, and tungsten nitride.

In particular embodiments, the integrated device includes a barrier layer formed over the base and the walls of the channel formed in the metal oxide layer. Suitable materials for the barrier layer include insulating or conductive materials that under the selected etching conditions are less susceptible to etching than the sacrificial material discussed below. Some suitable barrier materials include silicon dioxide, silicon, or silicon nitride, silicon carbide, silicon oxide nitrides, silicon carbide nitrides, aluminum, aluminum nitride, titanium, titanium nitride, tantalum, tantalum nitride, tungsten, tungsten carbide, and tungsten nitride and combinations thereof.

### BRIEF DESCRIPTION OF THE DRAWINGS

FIGs. 1a-e show a schematic representation of one process for forming an integrated device having substantially buried channels formed therein.

FIGs. 2a-f show a schematic representations of processes for forming an integrated device having substantially buried channels formed therein.

FIGs. 3a-b illustrate schematic representation of integrated devices according to embodiments of the invention.

FIG. 4 is a schematic representation of an integrated device according to another embodiment of the invention.

### DETAILED DESCRIPTION OF THE INVENTION

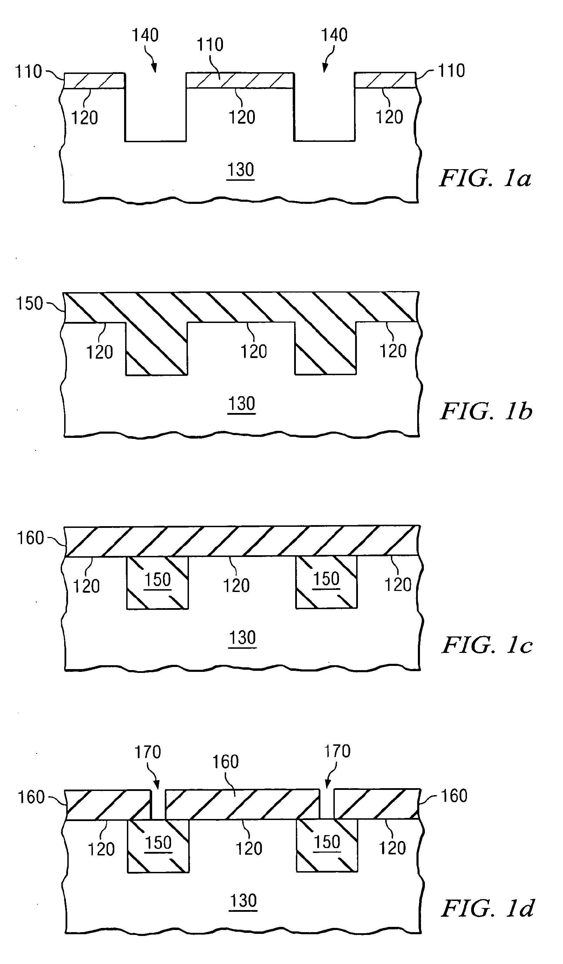

With reference to Figures 1a-e, one embodiment of a manufacturing process according to the present invention is described.

As illustrated in FIG. 1a, a hard mask 110 is initially formed on the surface 120 of a substrate 130. The metal oxide layer is optionally formed on a substrate such as a wafer of semiconductor material, for example silicon, using processing steps known in microelectronics. Subsequently, using the hard mask 110, the substrate 130 is etched to form channels 140 having a width, for example, of between 0.5 and 30 µm, and a depth of, for example, between 1 and 30 µm. The channels 140 are preferably parallel to one another and spaced 1-30 µm apart. Of course, any other configuration of channels 140 can be used. Typically, the hard mask 110 is removed after the channels 140 are formed. But in some embodiments, the hard mask 110 may be left in place.

As shown in FIG. 1b, the substrate 130 is covered with a sacrificial layer 150 that also fills the channels 140. The filling process can be performed using a chemical vapor deposition (CVD) processes such as LPCVD (low pressure CVD), APCVD (Atmospheric Pressure CVD) oxide deposition, PECVD (plasma enhanced CVD) TEOS (tetraethylorthosilicate) deposition, physical vapor deposition such as sputtering, or SOG (spin on glass). In particular embodiments, the sacrificial layer 150 is a spin-on glass. Some typical spin-on glasses include silica, organosilicate and doped silica compositions. In embodiments using a spin-on glass as the sacrificial material, a dispersion containing the desired oxide or non-oxide precursor is prepared and is applied to the substrate 130 by spinning, dipping, draining or spraying the dispersion onto the substrate 130. The sacrificial material forms a layer 150 over the exposed surface. The sacrificial layer 150 typically has a thickness between 50 and 500 nm greater than the depth of the channels 140. Some embodiments have a sacrificial layer 150 that has a thickness greater or less than this range since the thickness is a matter of controlling the solution viscosity. Typical solution viscosity for a spin-on glass is about 3-10 mPa-s. Typical surface tension is 30-50x10⁻³ N/m. A desired thickness of sacrificial layer 150 film thickness can be achieved by controlling the viscosity and concentration sacrificial material of the solution, as well as the spinning rate.

In some embodiments, the sacrificial material outside the channels 140 is removed. The manner by which the sacrificial material is removed is not critical. One method of removing the sacrificial material is by surface planarization using chemical mechanical polishing (CMP). An isotropic dry or wet etching suitable for removing the sacrificial material can also be used to removed undesirable portions of the sacrificial layers 150.

As shown in FIG. 1c, an encapsulating 160 layer is deposited over metal oxide layer and the filled channels 140. The encapsulating layer can be formed using a chemical vapor deposition (CVD) processes such as LPCVD (low pressure CVD), APCVD (Atmospheric Pressure CVD) oxide deposition, PECVD (plasma enhanced CVD) TEOS (tetraethylorthosilicate) deposition, physical vapor deposition such as sputtering, or SOG (spin on glass). In some embodiments, the encapsulating layer 160 is formed by molecular beam epitaxy (MBE). Some encapsulating layers range in thickness from about 10 to about 50 µm. Structures with an encapsulating layer 160 that is thinner or thicker are also used in certain embodiments since the thickness of the layer is not critical. As mentioned above, some suitable materials for the encapsulating layer 160 comprise silicon dioxide, silicon, silicon nitride, silicon carbide, silicon oxide nitrides, silicon carbide nitrides, aluminum, aluminum nitride, titanium, titanium nitride, tantalum, tantalum nitride, tungsten, tungsten carbide, and tungsten nitride or combinations thereof.

As depicted in FIG. 1d at least one aperture 170 is formed in the encapsulating layer 160 to expose the sacrificial layer 150. The aperture can be formed by any convenient means. In some embodiments, an aperture in the encapsulating layer 160 is formed by plasma etching using any convenient masking technique to define the area of the encapsulating layer that is to be removed to form the aperture 170. In particular embodiments, a plurality of apertures 170 are formed in the encapsulation layer 160 to expose underlying portions of the sacrificial layer 150. The number of apertures 170 that are formed should be sufficient to allow for substantially complete removal of the underlying sacrificial material to substantially return the channels 140 to their configuration before the sacrificial layer 150 was applied. Although any shape may be used, substantially circular apertures 170 are convenient. In a particular embodiment, the apertures 170 have a diameter of about 10 percent to about 75 percent of the width of the underlying channel 140. Thus, in embodiments where the channel has a width of 3 µm, the apertures should have a diameter ranging from about 0.3 mm to about 2.25 µm. Of course, the lower limit of the aperture size is determined by the method used to form the aperture 170. The upper limit on the size of the aperture 170 should be selected according to the intended use and considering the importance of exposing portions of the channels 140. In some embodiments, the apertures 170 have a spacing such that adjacent apertures are separated from each other by a distance of about 0.1 to about 5 aperture diameters. In other words, whatever diameter of aperture is formed in the encapsulating layer 160, the spacing is as measured by shortest distance between two adjacent apertures is about 0.1 to about 5 times the diameter of the selected aperture diameter. In some embodiments, the spacing is about 0.5 to about 2 times the diameter of the apertures 170. In other embodiments, the spacing is about 0.7 to about 1.5 times the diameter of the apertures 170.

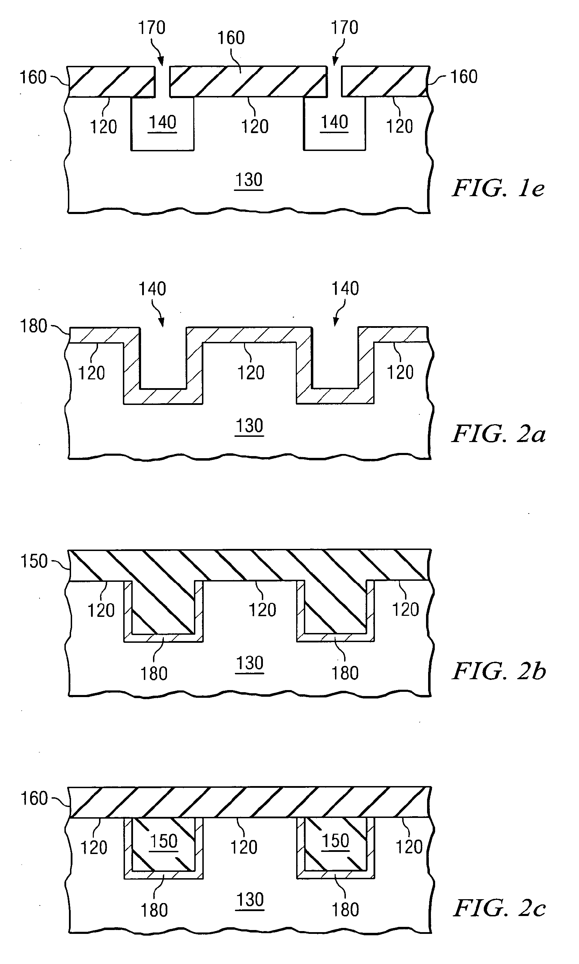

As FIG. 1e illustrates, once the apertures are formed, the remaining sacrificial layer 150 in the channels 140 is removed. In particular embodiments, the remaining sacrificial layer 150 is removed by wet etching with an appropriate etchant. The selection of an appropriate etchant depends upon the composition used as the encapsulating layer 160 and the optional barrier layer when it is present. One of ordinary skill in the art knows how to select an etchant according to the type of material that is to be removed. In some embodiments, the etchant is selected to etch the material that forms the sacrificial layer 150 at a faster rate than the substrate 130. Preferably, the etchant removes the sacrificial layer 150 faster than the substrate 130 and the encapsulating layer 160. In some embodiments, the etchant is HF. In particular embodiments the sacrificial layer comprises a silica or doped silica spin-on glass and the etchant is HF. Other etchants include cationic amine-containing compounds, such as, for example, hydrogenated amines and quaternary ammonium compounds. In particular embodiments the etchant is tetra-methyl-ammonium hydroxide (TMAH). Regardless of the choice of etchant, the etching procedure should be allowed to continue for a time sufficient to remove substantially all the sacrificial layer that was deposited in channels 140. In some embodiments, the etching procedure is allowed to continue for a period of from about 1 second to about 10 minutes. In certain embodiments, the etching time is about 15 seconds, 30 seconds, 45 seconds, or 90 seconds. Additionally, the total etching time may be segregated into several distinct etching steps. Of course, the etching time can be determined by routine experimentation and one skilled in the art understands that factors such as etchant efficacy, etchant concentration, and the composition of the sacrificial layer will affect the desired etching time. In embodiments, where more than one distinct etching step is used, a rinse step, usually with distilled water may be performed between the etching steps.

Another embodiment of the invention includes a substrate under the metal oxide layer. In some embodiments having a substrate under the metal oxide layer, the substrate comprises a monocrystalline semiconductor material, for example silicon. Any crystallographic orientation of the substrate is suitable depending on the design of the device. In some embodiments, a <110> or a <100> crystallographic orientation instead is used. In other embodiments, a wafer a having a <111> orientation is used. One of ordinary skill in the art understands how to select a suitable orientation of the substrate according to the layers to be formed thereon.

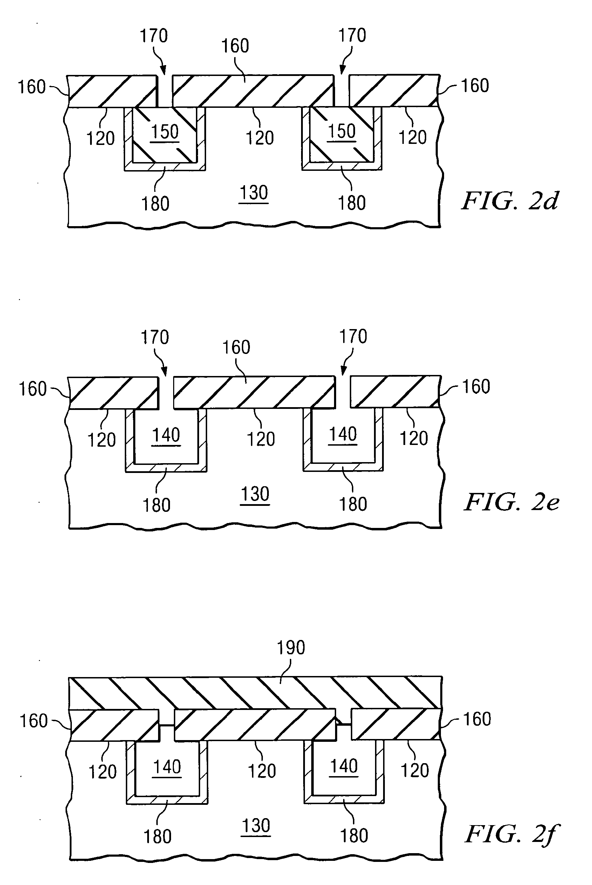

As shown in FIGs. 2a-e, some inventive processes include forming a barrier layer 180 interposing the metal oxide layer and the sacrificial layer 150. In some embodiments, the barrier layer 180 is formed over the base and sidewalls of the channel 140. In some embodiments, the barrier layer is formed over the base of the channel 140 or the walls of the channel 140. Some materials that are suitable for forming the barrier layers 180 comprise silicon dioxide, silicon, or silicon nitride, silicon carbide, silicon oxide nitrides, tetraethyl orthosilicate (TEOS), silicon carbide nitrides, aluminum, aluminum nitride, titanium, titanium nitride, tantalum, tantalum nitride, tungsten, tungsten carbide, and tungsten nitride. The barrier layer 180 can be formed by any means. Some barrier layers 180 are formed by a CVD process, while others are formed by a physical vapor deposition process, for example sputtering and have a thickness of between about 60 and about 100 nm. Some barrier layers 180 do not allow epitaxial growth. For this purpose, for instance, a fast oxidation step may be carried out, so as to grow an oxide layer, or else a layer of a material chosen among deposited oxide, nitride and tetraethyl orthosilicate (TEOS) may be deposited in a similar way. In some embodiments, the barrier layers are formed are described in U.S. Patent No. 6,673,593, incorporated herein by reference in its entirety. FIGs 2b-e depict processes analogous to those depicted in FIG 1b-e.

As shown in FIG. 2f, some processes also include forming a sealing layer 190 over the encapsulating layer 160. The choice of material used to form the sealing layer is not critical and it can be formed by any method. Of course, it is desirable to use a method that does not deposit undesirable amounts of material in the channels 140.

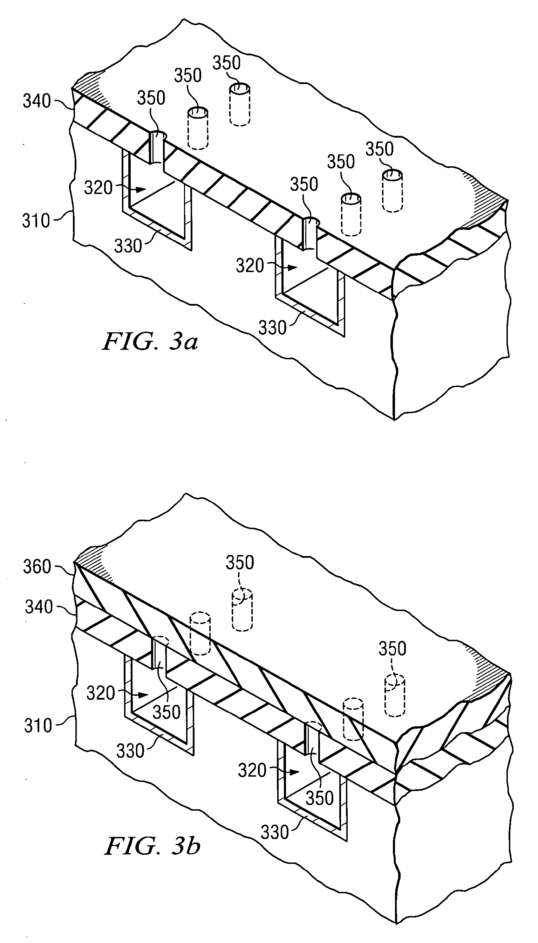

In another aspect the invention provides an integrated device as schematically shown in FIGs. 3a-b. FIG. 3a shows an integrated device 300 comprising a substrate 310 having at least one channel 320 formed in its surface. Figure 3 depicts the device 300 with an optional barrier layer 330 lining the base and walls of the channel. But in other embodiments the barrier layer 330 may also interpose the substrate 320 and an encapsulating layer 340. The encapsulating layer 340 includes at least one aperture 350 located over the at least one channel 320. In embodiments having a plurality of channels 320, the encapsulating layer 340 has at least one aperture 350 located over each of the channels 320. In preferred embodiments, the encapsulating layer 340 has a plurality of apertures 350 located over each of the channels 320 of the integrated device 300. Preferably, the apertures 350 are discrete and spaced apart from one another. In certain embodiments, the integrated device also includes a sealing layer 360 over the encapsulating layer (see FIG. 3b). The sealing layer 360 may or may not substantially fill the apertures 350.

The choice of material for the substrate 310 of device 300 is not critical. Some suitable substrates include monolithic silicon wafers, polysilicon, silicon dioxide and organic polymers such as but not limited to poly-alpha-olefins homopolymers and copolymers. In particular, polyethylene and polypropylene homopolymer and copolymers can be used. Metal oxides can also be used as the substrate. Particularly useful metal oxides include those metal oxides containing at least one Group 3-15 and oxygen. In some embodiments, the substrate 310 comprises silicon dioxide, aluminum oxide, silicon aluminum oxide, titanium dioxide, one or more tantalum oxides such as tantalum pentoxide, or tungsten oxide. In a preferred embodiment the substrate 310 is a silicon dioxide layer.

The channels 320 extend in the surface of the metal oxide layer 310 in a desired configuration. In particular embodiments, the channels 320 extend substantially parallel to each other, in the lengthwise direction of the integrated device 300, at a desired distance from the surface of the integrated device 300. While they may have any desired dimension, the channels 320 may have a roughly circular or rectangular section, may be spaced 1-30 µm apart, and may be set at a depth of 5-10 µm from the surface of the integrated device 300.

The encapsulating layer 340 of the integrated device 300 is located over at least a portion of the substrate 310 and the one or more channels 320 formed therein. Any suitable material can be used as the encapsulating layer 340. In some embodiments, the encapsulating layer 340 comprises an insulating material. In other embodiments, the encapsulating layer 340 comprises a conductive material. Some embodiments include an encapsulating layer that comprises a two or more distinct layers. Typically, the encapsulating layer 340 ranges in thickness from about 50 nm to about 50 µm. Structures with an encapsulating layer 340 that is thinner or thicker are also used in certain embodiments since the thickness of the layer is not critical. Typically, where more than one layer forms the encapsulating layer 340 the individual layers have different compositions, but they may also have the same composition yet are formed in a separate step or in the same process step under a different set of conditions. Suitable materials for use as encapsulating layers include silicon dioxide, silicon, silicon nitride, silicon, carbide, silicon oxide nitrides, carbide nitrides, silicon oxide carbide, aluminum, aluminum nitride, titanium, titanium dioxide, titanium nitride, tantalum, tantalum nitride, tungsten, tungsten carbide, tungsten nitride, and combinations thereof.

The encapsulating layer 340, whether it comprises one or more individual layers, has at least one aperture located over the channel 320. In embodiments having two or more channels 320 in the substrate 310, the encapsulating layer 340 has at least one aperture 350 located over each channel 320. In some embodiments, the encapsulating layer 340 has a plurality of apertures formed therein. The one or more apertures 350 can be formed by any means. In some embodiments, the apertures 350 are formed by a wet etching process, such as etching with TMAH or HF. Depending on the selection of materials, the apertures can also be formed by a dry etching process. Appropriate etching times depend on the choice of etchant and the composition of the encapsulating layer 340. As is known in the art, forming the apertures 340 by etching also includes photolithographic process where a hard mask is formed over the encapsulating layer. The mask maybe either a positive mask or a negative mask.

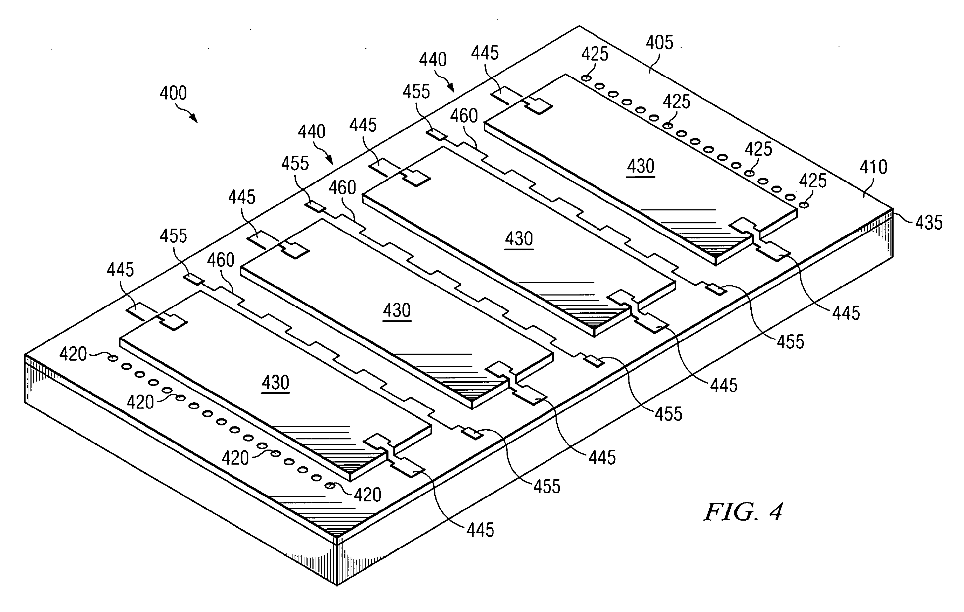

Embodiments of the invention described herein can form a part of larger structures such as microreactor, preferably a DNA microreactor. FIG. 4 shows an integrated device 400 comprising a body 405 of semiconductor material, typically monocrystalline silicon, having a surface 410 and parallelepiped shape. Heating elements 430 are present on the surface 410 of the body 405. The body 405 is traversed by a plurality of channels as described herein above (not shown) connected to the surface 410 of the body 405 through inlet ports 420 and outlet ports 425, which are connected to the ends of the channels. In the device 400 the channels are connected, directly or indirectly, to the surface of the integrated device through an inlet port. Inlet and outlet ports can be formed as described in U.S. Patent No. 6,673,593. For instance, in some embodiments, all or substantially all of the channels are connected to a single inlet port. In some embodiments, the device has more than one inlet port and outlet port. All or substantially all of the channels are connected to the same inlet in some embodiments. In other embodiments, each inlet is connected to a defined number of channels. And in some embodiments, a defined number of channels are connected to each outlet. In a particular embodiment, each channel connects one inlet port to one outlet port.

In detail, the channels extend parallel to each other, in the lengthwise direction of the body 405, at a preset distance from the surface 410. For example, the channels can have a roughly circular or rectangular section and can be spaced 50 µm, with a depth of 5-10 µm from the surface 410. In the case of channels with a rectangular section, the channels have a side of approximately 30 × 200 µm and occupy an area of 5 × 10 mm.

Preferably, the heating elements 430 are formed, as been mentioned, on the surface 410 of the body 405 and are insulated from the body 405 by an electrically insulating material layer 435, for example silicon dioxide.

Each of the heating elements 430 in the illustrated embodiment, comprise a rectangular region that extends transversely with respect to the extension of the channels, and the heating elements 430 are adjacent to each other so as to practically cover the entire portion of the surface 410 overlying the channels, except for intermediate strips 440 of the surface 410. Each of the heating elements 430 is connected by two electric connection regions 445 arranged on the opposite shorter sides of each of the heating elements 430.

In particular embodiments, sensor elements 450 extend above the intermediate strips 440 of the surface 410, and include for example coil-shaped metal regions that are represented schematically and are connected at their ends to contact regions 455. The sensing elements 460 are of a material having a resistance that varies with the temperature and are connected to a resistance sensing circuit of known type, for example of bridge type, not illustrated and preferably formed in the body 405.

In use, the liquid to be treated and/or to be made to react with a reagent is introduced from a reservoir located above the integrated device 400 through the inlet ports 420, is forced to flow through the channels, and is possibly mixed with appropriate reagents at a controlled temperature. The heating elements 430 maintain a controlled temperature throughout the channel area; in particular, because of its micrometric dimensions, the buried channel is evenly heated, and there is no temperature gradient along and across the channels themselves.

According to the treatment to be carried out, it is possible to perform a series of heat cycles, each time controlling the temperature with precision as desired for a preset time by virtue of the temperature sensors cooperating with a suitable control system of known type. The treated and/or reacted liquid exits the integrated device 400 through the outlet port or ports 425.

Finally, it is clear that numerous variations and modifications may be made to the device and to the manufacturing process described and illustrated herein, all falling within the scope of the invention, as defined in the attached claims. For example, the integrated device 100 may also include heating elements and/or sensor elements that extend above the encapsulating layer or along the channels 420 in any other suitable configuration, as described in U.S. Patent No. 6,673,593 incorporated herein by reference in its entirety for the purposes of U.S. patent practice. In some embodiments, the integrated device 400 includes coil-shaped metal regions connected at their ends to contact regions. In some embodiments, sensing elements comprise a material having a resistance that varies with the temperature and are connected to a resistance sensing circuit of any desirable configuration, such as but not limited to bridge type resistance circuits that are formed in the integrated device 400. In a way which is not illustrated, the body 405 may integrate electronic components for controlling the temperature and/or for processing the signals picked up by the integrated device. For example, instead of having a plurality of channels that connect inlet ports 420 to outlet ports 425, the thermoregulation device 400 may comprise a single buried channel of a suitable width, and the channels may be set at a distance whereby, in the subsequent timed etching for forming the channels, the silicon between the channels themselves is removed completely.

## Claims

1. A method of manufacturing an integrated device, comprising:
a) filling at least one channel region of a substrate with a sacrificial material to form a filled channel;
b) forming an encapsulating layer over the filled channel;
c) forming an aperture in the encapsulating layer; and
d) selectively removing through the aperture the sacrificial material in the channel region.

2. The method of claim 1, further comprising providing an etch stop layer under the substrate.

3. The method of claim 2 wherein the etch stop layer is silicon, silicon nitride, silicon dioxide, or titanium nitride.

4. The method of any preceding claim, further including forming a barrier layer over the walls and bottom of the channel.

5. The method of any preceding claim, wherein the sacrificial material is a spin on glass (SOG).

6. The method of claim 5, wherein the spin on glass (SOG) is selected from the group of materials consisting of silica, organosilicated and doped silica compositions.

7. The method of any preceding claim, further comprising a heating step prior to forming the encapsulating layer.

8. The method of any preceding claim, wherein the sacrificial layer has a faster etching rate than the substrate and/or the encapsulating layer.

9. The method of any preceding claim, wherein the aperture is formed by etching.

10. The method of any preceding claim, wherein selectively removing the sacrificial material comprises providing an etchant.

11. The method of claim 10, wherein the etchant is hydrofluoric acid.

12. A method of manufacturing an integrated device, comprising:
a) filling at least one channel of a substrate with a spin on glass material to form a filled channel;
b) forming an encapsulating layer over the filled channel;
c) etching an aperture in the encapsulating layer; and
d) applying an etchant through the aperture in the encapsulating layer, wherein the etchant removes the spin on glass material at a faster rate than the etchant removes the encapsulating layer.

13. A method of manufacturing an integrated device, comprising:
a) filling at least one channel region of a silicon substrate with silicon dioxide to form a filled channel;
b) forming an encapsulating layer over the filled channel wherein the encapsulating layer comprises silicon dioxide, silicon, silicon nitride, silicon carbide, silicon oxide nitrides, silicon carbide nitrides, aluminum, aluminum nitride, titanium, titanium nitride, tantalum, tantalum nitride, tungsten, tungsten carbide, and tungsten nitride.;
c) etching an aperture in the encapsulating layer; and
d) applying an etchant through the aperture to selectively remove the sacrificial material in the channel region.

14. A method of forming an integrated device for microfluid thermoregulation, comprising:
a) forming a plurality of buried channels in a substrate by etching an encapsulating layer located over a plurality of filled channels located in the substrate, wherein the etching forms at least one aperture over each of the filled channels and applying an etchant through the aperture to form a plurality of channels in the substrate;
b) forming first and second ports in the substrate to be in fluid communication with the surface of the substrate and at least one of the plurality of buried channels; and
c) forming a heating element on the surface of the substrate and located over at least one of the plurality of channels for heating a fluid in the channel.

15. The method of claim 14, wherein the etching forms a plurality of apertures over each of the filled channels.

16. The method of claim 14 or 15 further including forming a sealing layer over the encapsulating layer.

17. An integrated device having a substrate, comprising:
a) at least one channel formed in the substrate; and
b) an encapsulating layer located over the substrate and over at least a portion of the channel, the encapsulating layer having at least one aperture located over the channel.

18. The integrated device of claim 17, further comprising a support under the substrate and wherein the support comprises a silicon wafer.

19. The integrated device of any of claims 17 to 19, wherein the device comprises a plurality of apertures that are discrete and spaced apart.

20. The integrated device of claim 19 further including a sealing layer over the encapsulating layer and substantially filling the plurality of apertures.

21. An integrated device comprising:
a) at least one channel formed in the a silicon or silicon dioxide substrate;
b) an encapsulating layer located over the substrate and over at least a portion of the channel, the encapsulating layer having a plurality of apertures located over the channel, wherein the encapsulating layer comprises silicon dioxide, silicon, silicon nitride, silicon carbide, silicon oxide nitrides, silicon carbide nitrides, aluminum, aluminum nitride, titanium, titanium nitride, tantalum, tantalum nitride, tungsten, tungsten carbide, and tungsten nitride; and
wherein the plurality of apertures are discrete and spaced apart.

22. An integrated device comprising:
a monolithic silicon support;
a silicon dioxide or polysilicon layer formed over the support and having a channel formed therein; and
an encapsulating layer formed over the silicon dioxide layer, wherein the encapsulating layer has a plurality of spaced apart apertures located over the channel.

23. An integrated device for microfluid thermoregulation, comprising:
a) a monolithic silicon substrate having a surface;
b) a plurality of buried channels extending parallel and adjacent to each other in the substrate, arranged at a distance from said surface, and each buried channel having a first and a second end;
c) at least one first port and at least one second port extending from said surface respectively as far as said first end and second end of each buried channel, and being in fluid connection with each buried channel;
d) an encapsulating layer over the plurality of channels, wherein the encapsulating layer includes at least one aperture formed therein and located over each channel; and
e) at least one heating element arranged on said semiconductor material body.

24. The device of claim 23, comprising a plurality of apertures located over each of the channels.

25. The device of claim 22, 23 or 24, further comprising a sealing layer over the encapsulating layer.

26. The integrated device of any of claims 17 to 25, further comprising a barrier layer formed over the base and the walls of the channel.

27. The method or integrated device of any preceding claim, wherein the barrier layer comprises an insulating or conductive layer comprising silicon dioxide, silicon, silicon nitride, silicon carbide, silicon oxide nitrides, silicon carbide nitrides, aluminum, aluminum nitride, titanium, titanium nitride, tantalum, tantalum nitride, tungsten, tungsten carbide, and tungsten nitride.

28. The method or integrated device of any preceding claim, wherein the encapsulating layer comprises an insulating or conductive layer comprising silicon dioxide, silicon, silicon nitride, silicon carbide, silicon oxide nitrides, silicon carbide nitrides, aluminum, aluminum nitride, titanium, titanium nitride, tantalum, tantalum nitride, tungsten, tungsten carbide, and tungsten nitride.

29. The method or device of any preceding claim, wherein the substrate comprises silicon, polysilicon, silicon dioxide or an organic polymer.
